Europäisches Patentamt

European Patent Office

Office européen des brevets

(11) Publication number: **0 280 073**
**A2**

# EUROPEAN PATENT APPLICATION

(21) Application number: 88101464.1

(22) Date of filing: 02.02.88

(51) Int. Cl.⁴: **H01C 1/142**

(30) Priority: 23.02.87 JP 37997/87

(43) Date of publication of application:
31.08.88 Bulletin 88/35

(84) Designated Contracting States:
DE FR GB

(71) Applicant: **HITACHI, LTD.**
**6, Kanda Surugadai 4-chome**
**Chiyoda-ku Tokyo 101(JP)**

Applicant: **HITACHI MICROCOMPUTER**
**ENGINEERING LTD.**
**1479, Josuihon-cho**
**Kodaira-shi Tokyo(JP)**

(72) Inventor: **Haruhiko, Imada**
**682-15, Horinishi**
**Hadano-shi Kanagawa-ken(JP)**
Inventor: **Takaji, Takenaka**
**1523-6, Hirasawa**
**Hadano-shi Kanagawa-ken(JP)**
Inventor: **Minoru, Tanaka**
**2-33-12, Hirato, Totsuka-ku**
**Yokohama-shi Kanagawa-ken(JP)**
Inventor: **Akira, Murata**
**1-2-2, Torigoe, Taitou-ku**
**Tokyo(JP)**
Inventor: **Mitsuru, Usui**
**Chishin-ryo, 24-1, Hirasawa**
**Hadano-shi Kanagawa-ken(JP)**
Inventor: **Yasunori, Narizuka**
**555 Hachimanyama-apartment, 1545,**
**Yoshida-cho**
**Totsuka-ku Yokohama-shi Kanagawa-ken(JP)**

(74) Representative: **Patentanwälte Beetz sen. -**
**Beetz jun. Timpe - Siegfried -**
**Schmitt-Fumian- Mayr**
**Steinsdorfstrasse 10**
**D-8000 München 22(DE)**

(54) Circuit substrate with resistor elements.

(57) Herein disclosed is a circuit substrate 11 which comprises a resistor element including a resistance film 12 formed on the surface of the wiring layer of an electric circuit and a conductor electrode 14 formed out of a conductor overlapping the resistance film 12. A wiring thick conductor electrode 13 is formed to partially overlap the upper or lower side of the end portion of the resistance film 12. The upper side of the resistance film 12 is partially covered so as to set the resistance of the resistor element and to strengthen the electric connection between the resistance film 12 and the thick conductor electrode

13. There are also covered both the overlapping portion of the resistance film 12 and the thick conductor electrode 13 and a part of the exposed portion of the conductor electrode 13 or the resistance film 12 continuous to the overlapping portion.

*FIG. 2a*

*FIG. 2b*

## CIRCUIT SUBSTRATE WITH RESISTOR ELEMENTS

### BACKGROUND OF THE INVENTION

The present invention relates to a circuit substrate for packaging electronic components and, more particularly, to a structure of a resistor element to be formed on or in a substrate.

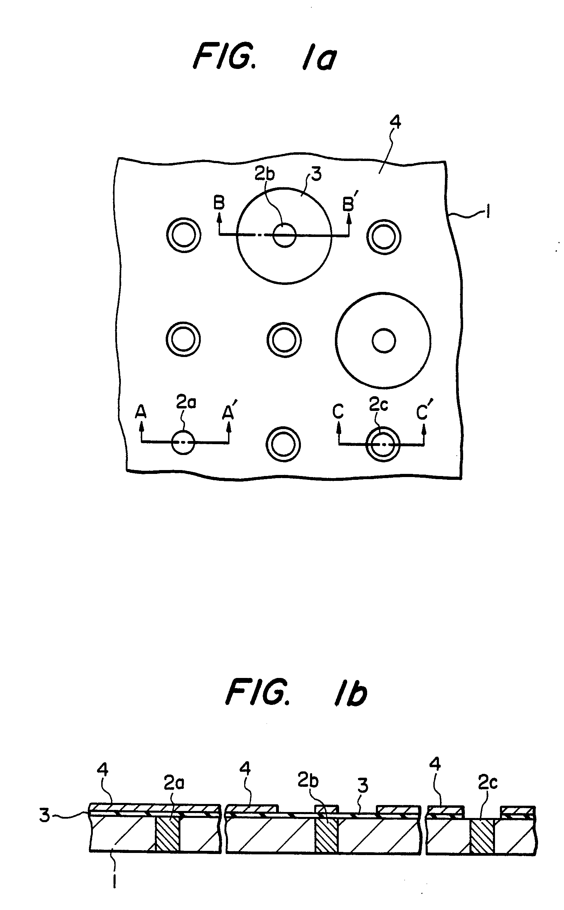

In an electrode structure used widely in a resistor element of the prior art, the electrode is formed by arranging a conductor in contact with at least one of upper and lower sides at each of the two ends of a square resistance film. The electrode structure as disclosed in Japanese Patent Laid-Open No. 136391/1985 will be described in summary with reference to Fig. 1a. A substrate 1 is formed in its surface with a electrode conductor (e.g., a circular through-hole conductor extending through the back of the substrate 1) 2b. This circular electrode conductor 2b is concentrically surrounded by a film resistor 3 which forms part of a resistance layer on the substrate 1. Another electrode conductor 4 is formed on the outer circumference of the film resistor 3. Here, as shown in Fig. 1b, the resistor 3 is once formed on the substrate 1 by the sputtering process. Then, the conductor layer is formed on the resistor 3 and partially removed by the etching process or the like to shape the resistor 3 interposed between the two electrode conductors. Specifically, the resistor 3 is interposed between one electrode conductor 2b and the other electrode conductor 4, thus constituting one resistor element.

However, this resistor element having the structure of the prior art is still insufficient for the recent requirements such as high integration, size reduction or high precision (or accuracy) of the set values, e.g., the resistance of a circuit element. In other words, the prior art took no consideration from the point of forming a resistor element of high precision resistance but underwent the trimming process for partially removing the resistance film forming part of the resistor element to control resistance. The trimming process incurs more or less error in the area of the resistance film so that the distribution of the current flowing through the resistance film becomes uneven.

As a result, local current concentration arises due to the unevenness of the current distribution so that the resistance film generates heat to damage the substrate, in which the resistor element is arranged, and to highly fluctuate the resistance of the resistor element due to aging.

### SUMMARY OF THE INVENTION

An object of the present invention is to provide a circuit substrate including a resistor element having a high precision resistance while eliminating the trimming process of the prior art.

In order to achieve the object, according to the present invention, there is provided a circuit substrate which comprises: a first electrode conductor made of a relatively thick wiring conductor and overlapping partially the upper or lower side of a resistance film; and a second electrode conductor made of a relatively thin conductor and covering the overlapping portion of said resistance film and said first electrode conductor and at least a portion of the exposed portion (of said first electrode conductor) continuing from said overlapping portion.

### BRIEF DESCRIPTION OF THE DRAWINGS

Fig. 1a is a top plan view showing the construction of a circuit substrate having a resistor element according to the prior art;

Fig. 1b is a partial section of the structure shown in Fig. 1a;

Figs. 2a and 2b are a partial section and a top plan view, respectively, and show one embodiment of the circuit substrate according to the present invention, in which a concentric resistor element is formed; and

Figs. 3a and 3b are a partial section and a top plan view, respectively, and show another embodiment of the circuit substrate according to the present invention, in which a square resistor element is formed.

### DESCRIPTION OF THE PREFERRED EMBODIMENTS

One of the major factors exerting influences upon the precision of the resistance owned by the resistor element is the shape and dimensional precisions of conductors forming the electrodes of the resistor element. If the area to be occupied by the resistor element is especially restricted for high density wiring, the shape and dimensional precisions of the conductors forming the electrodes constitute major factor for the fluctuations of the resistance.

Noting this point, the circuit substrate of the present invention comprises a first electrode formed out of a thick wiring conductor in advance on upper or lower side of a resistance film. After this, a second electrode of a thin conductor is formed to have a larger area overlapping on the resistance film than that of the thick conductor. As a result, what determines the resistance of the resistor element formed by the resistance film is not the shape and size of the thick conductor forming the first electrode but that of the thin conductor forming the second electrode. The etching process per se of this thin conductor can be accomplished with ease and in high precision. Thus, the advantage of this case is that resistance can be determined easily but precisely without any trimming process.

In the circuit substrate of the present invention, moreover, the first electrode of the resistor element is formed out of the relatively thick wiring conductor, and the resistance film is connected directly with the thick electrode and is in sufficient contact with the resistance film through the second electrode conductor. As a result, the interconnection of the resistor element with another electric circuit raises no problem such as an increase in the wiring resistance.

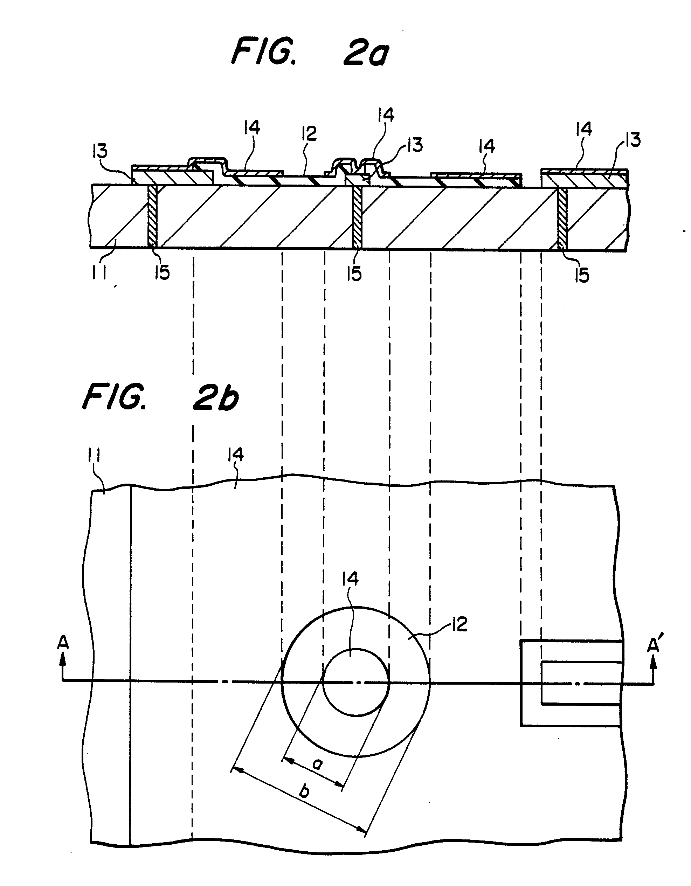

One embodiment of the present invention will be described in the following with reference to Figs. 2a and 2b.

Fig. 2a is a section showing the circuit substrate which has a resistor element on the surface of a substrate 11. Numeral 13 designates a thick conductor which forms a first electrode of the resistor element and is connected with a through hole 15. Numeral 14 designates a thin conductor which forms a second electrode on a resistance film 12.

Fig. 2b is a top plan view showing the construction of the circuit substrate of the present invention and has its section taken along dotted line and presented in Fig. 2a.

The process for fabricating this circuit substrate will be described in the following.

As shown in Fig. 2a, the thick conductor layer 13 is formed all over the surface of the substrate 11 which is made of an inorganic material such as ceramics or an organic material such as resins. The conductor layer is etched by the photoetching process or the like except the portion corresponding to the through-hole 15 and another desired electrode portion. Thus, the wiring electrode 13 connected with the portion of the through hole 15 and the first electrode serving as a connecting conductor of the resistor element are formed.

The thickness of the first electrode conductor 13 is set at a lower level than the wiring resistance required of the circuit substrate to be fabricated. Next, the resistance film 12 is formed all over the surface by the thin-film process such as the sintering, evaporating or sputtering of thick paste. The resistance film 12 is photoetched except the region for the arrangement of the resistance element.

Here, the resistance film 12 is made to overlap the conductor partially. Then, the conductor 14 thinner than the conductor 13 is layered all over the surface of the substrate having the first electrode and the resistance film and is as shown by Fig. 2b photoetched away at both a circular thin conductor portion 14 for the second electrode over an electrode 13 disposed at the center of the resistance film 12 and a portion of the thin conductor 14 concentric to the portion 14, thus forming the second electrode 14 to be connected with the resistance film 12. In this case, the conductor 14 is removed at the unnecessary portion so that it may not be short-circuited with another wiring. The diameter of the second circular electrode formed out of the conductor 14 is made larger than that of the first electrode formed out of the conductor 13 and positioned at the center of the resistance film 12, and the conductor 13 should not extend out to the exposed annular portion of the resistance film 12. As a result, the resistance of the resistor element is determined under the sheet resistance of the film 12 exclusively by the shape and size of the conductor 14, i.e., by the sizes of the internal diameter a and external diameter b of the annulus shown in Fig. 2b in the present embodiment. Here, the resistance film is assumed to have a constant thickness.

In case the conductors are to be etched so as to form the first and second electrodes, the shape and size will fluctuate depending upon the under-or overetching due to the fluctuations of the working conditions. Despite of this fact, however, the time period required for the etching process in the shorter for the thinner conductors. Then, the thin conductors can afford high precision shape and size without being highly influenced by the fluctuations of the etching conditions. This makes it possible to make the conductor 14 thin to such an extent (e.g. , 1 microns) that the resistance of the second electrode itself is not high.

Thus, the resistance is controlled by using a thin conductor so that a resistance film having a high precision resistance can be formed. Since, moreover, a first thick electrode is used as one for wiring the resistance film, the resistor element can be connected with another electric circuit without increasing the wiring resistance.

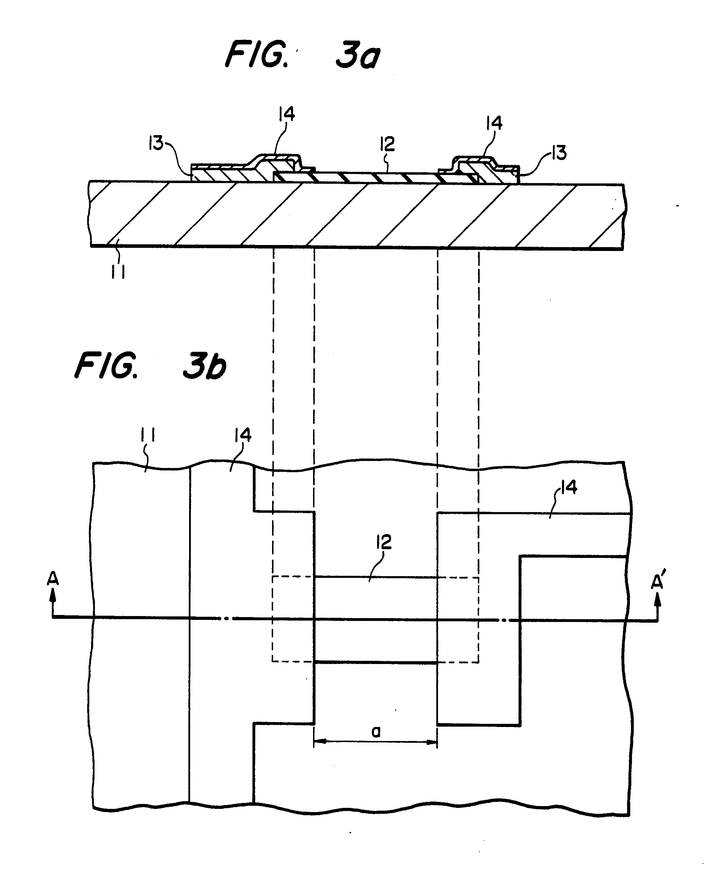

Another embodiment of the circuit substrate having a square resistor element will be described in the following with reference to Figs. 3a and 3b.

Fig. 3a is a section showing a circuit substrate having a resistor element formed out of a square resistance film. The thick conductor 13 is a first electrode formed on the resistance film 12 and provides a wiring for connecting the resistor element with another electric circuit. The thin conductor 14 forms a second electrode which is constructed to partially overlap the conductor 13 and the resistance film 12.

Fig. 3b is a top plan view showing the present circuit substrate, and Fig. 3a is a section taken along line A - A' of Fig. 3b.

The present circuit substrate can be fabricated similarly to the embodiment of Figs. 2a and 2b except that the forming order is the resistance film 12, the conductor 13 and the conductor 14.

In the present circuit substrate, too, the thin conductor 14 forming the second electrode overlaps the resistance film 12 with a wider area than that of the thick conductor forming the first electrode. As a result, the resistance owned by the resistor element is determined by the size a and the width W of the square resistance film, as shown in Fig. 3b. Because the conductor 14 is thin, moreover, the conductor 14 can be worked in high precision with respect to the size a. Because the thickness of the resistance film is usually as small as about 0.1 microns, still moreover, the resistance film can also be worked in high precision. Thus, it is possible to form a resistor element having a high precision resistance. Because the thick conductor forms both the first electrode and the wiring, furthermore, the resistor element can be connected with another electric circuit without increasing the wiring resistance.

According to the present invention, the resistor element having a high precision resistance can be formed while eliminating the trimming process of the prior art for controlling the resistance. This clears away the disadvantage that the aforementioned local overheat due to the uneven distribution of the current flowing through the resistance film as a result of the trimming process is caused to damage the material of the substrate forming the resistor element. Also eliminated is another disadvantage that the resistance of the resistor element will be fluctuated due to aging by that local overheat. Thus, a high effect is obtained to improve the reliability of the substrate forming the resistor element. The elimination of the trimming process is highly effective in shortening the process for fabricating the substrate having the resistor element.

Incidentally, the embodiments of the present invention thus far described are exemplified by a single substrate. The structure of the present invention can naturally be applied to the internal wiring layer of the structure having a multilayer interconnection circuit.

## Claims

1. A circuit substrate comprising a resistor element including a resistance film formed on the surface of the wiring layer of an electric circuit and a conductor electrode formed out of a conductor overlapping said resistance film,

wherein the improvement comprises:

a first electrode 13 made of a thick conductor and formed to partially overlap at least either the upper or lower side of said resistance film 12; and

a second electrode 14 made of a thin conductor and formed to partially overlap said resistance film 12 and to cover said thick conductor 13.

2. A circuit substrate according to Claim 1, wherein said second electrode 14 covers both the overlapping portion of which said first electrode 13 and resistance film 12 partially overlapped upper side of said first electrode 13 and a part of the exposed portion of said conductor electrode 13 continuous to said overlapping portion.

3. A circuit substrate according to Claim 1, wherein said second electrode 14 covers both the overlapping portion of which said resistance film 12 and said first electrode 13 partially overlapped upper side of said resistance film 12 and a part of the exposed portion of said resistance film 12 continuous said overlapping portion.

# FIG. 1a

# FIG. 1b

## FIG. 2a

## FIG. 2b

# FIG. 3a

13    14    12    14    13

11

# FIG. 3b

11    14    14

A    12    A'

a